# EUROPEAN PATENT APPLICATION

(11) **EP 4 841 636 A1**
(43) Date of publication of application: **18.11.2026**
(21) Application number: 25177059.0
(22) Date of filing: 16.05.2025
(51) Int. Cl.: G11C 16/04, G11C 16/10

(54) **A NON-VOLATILE MEMORY AND A METHOD FOR WRITING TO A NON-VOLATILE MEMORY**

(71) Applicant: Imec VZW, 3001 Leuven (BE)
(72) Inventor: HIGASHI, Yusuke, 3001 Heverlee (BE); VERRECK, Devin, 3212 Pellenberg (BE); BREUIL, Laurent, 1040 Etterbeek (BE)
(74) Representative: AWA Sweden AB

(57) **Abstract**

A method comprising:
providing holes by gate induced drain leakage in a first transistor (136) of a first string (110);
injecting the holes into the channel (150) of a second transistor (138) of the first string (110), the second transistor (138) being a memory transistor (134) of the first string (110); and
programming the second transistor (138) by applying a negative voltage to the word line (144) connected to the second transistor (138) such that electrons tunnel from a gate (156) to a charge trap (160) of the second transistor (138);
wherein, during providing the holes, a first voltage is applied to a first bit line (101), a second voltage is applied to a second bit line (102) and a third voltage is applied to a control line connected to the first transistor (136), wherein a difference between the second and third voltages is smaller than a difference between the first and third voltages.

## Description

### TECHNICAL FIELD

The present inventive concept relates, in general, to a non-volatile memory and a method for writing to a non-volatile memory.

### BACKGROUND

A non-volatile memory is a type of memory that retains stored data also when not powered. One type of non-volatile memory is the 3D NAND flash memory.

### SUMMARY

It is an objective of the present inventive concept to facilitate a high programming efficiency of a non-volatile memory. It is a further objective to facilitate a high reliability of the non-volatile memory and/or to suppress programming disturbances in the non-volatile memory. It is a further objective to facilitate gate side injection operation of a non-volatile memory. It is a further objective to facilitate a non-volatile memory which is compact and/or has a high bit density. In particular, it is an objective to facilitate the above in a 3D NAND memory, such as a 3D NAND flash memory.

These and other objectives of the inventive concept are at least partly met by the invention as defined in the independent claims. Preferred embodiments are set out in the dependent claims.

According to a first aspect there is provided a method for writing to a non-volatile memory, the non-volatile memory comprising:
a first bit line and a second bit line;
a first string and a second string, the first string being connected to the first bit line and the second string being connected to the second bit line,
   each string comprising a plurality of transistors, the plurality of transistors comprising a selector transistor and a plurality of memory transistors, wherein each transistor comprises a source, a drain, a channel, and a gate, and each memory transistor further comprises a charge trap, wherein a first capacitance between the charge trap and the channel of the memory transistor is larger than a second capacitance between the charge trap and the gate of the memory transistor;
a plurality of control lines comprising
   a selector line connected to the gate of the selector transistor of the first string and to the selector transistor of the second string; and
   a plurality of word lines, each word line being connected to the gate of a memory transistor of the plurality of memory transistors of the first string and to a memory transistor of the plurality of memory transistors of the second string;
the method comprising:
   providing holes by gate induced drain leakage 'GIDL' in a first transistor of the first string, the first transistor being the selector transistor of the first string or one of the plurality of memory transistors of the first string,
   injecting the holes into the channel of a second transistor of the first string, the second transistor being one of the plurality of memory transistors of the first string; and
   programming the second transistor by applying a negative voltage to the word line connected to the second transistor such that electrons tunnel from the gate of the second transistor to the charge trap of the second transistor;
   wherein, during said act of providing the holes, a first voltage is applied to the first bit line, a second voltage is applied to the second bit line and a third voltage is applied to the control line connected to the first transistor, the first voltage being positive and the third voltage being negative, wherein a difference between the second and third voltages is smaller than a difference between the first and third voltages.

The non-volatile memory may be a semiconductor channel based non-volatile memory. For example, the non-volatile memory may be a flash memory, such as a NAND memory, e.g. a 3D NAND flash memory.

For each string, the transistors of the string may be connected in series. Within the string, the drain of each transistor may be connected to the source of a consecutive transistor. The string may extend vertically. The selector transistor may be arranged at one of the ends of the string, e.g. at the top end or the bottom end. Each memory transistor may constitute a memory cell. The string may comprise e.g. 32 to 256 memory transistors, or more.

Each selector transistor may be a string select transistor (SSL). The selector transistor may be arranged to connect one end of the string to the bit line of said string. The selector transistor may isolate the selected string from other strings in the non-volatile memory, facilitating that operations on one string do not affect other strings.

As mentioned, each memory transistor further comprises a charge trap, wherein a first capacitance between the charge trap and the channel of the memory transistor is larger than a second capacitance between the charge trap and the gate of the memory transistor. In other words, the memory transistors may be seen as gate side injection memory transistors. When the capacitance between the charge trap and the channel is larger than the capacitance between the charge trap and the gate, it may be easy to tunnel charge carriers from the gate to the charge trap, e.g. easier to tunnel charge carriers from the gate to the charge trap than from the channel to the charge trap. In this context, there are two types of charge carriers of opposite charge: electrons and holes.

In accordance with the above, the memory transistors may be programmed by tunnelling electrons from the gate to the charge trap. This is in contrast to the conventional approach where electrons tunnel from the channel to the charge trap.

The charge trap may be a so-called charge trapping layer or a so-called floating gate. The charge trap may be arranged between the gate and the channel of the transistor. A first dielectric layer may be arranged between the charge trap and the channel, and a second dielectric layer may be arranged between the charge trap and the gate. The first dielectric layer may be thicker than the second dielectric layer, e.g. at least 50% thicker or at least 100% thicker. This may facilitate that the first capacitance is larger than the second capacitance. Additionally, or alternatively, the first and second dielectric layer may comprise different dielectric materials. The first and second dielectric layer may respectively comprise oxide.

The first dielectric layer may be called block oxide layer. The first dielectric layer may comprise e.g. HfO₂, HfZrOx, AlOx or SiO₂.

The second dielectric layer may be called tunnel oxide layer. The second dielectric layer may comprise e.g. SiO₂ or SiON.

The first and second dielectric layer may comprise plural different dielectric material layers. e.g. AlOx and SiO2 for first layer SiON and HfO2 for second layer.

In view of the above, each of the plurality of memory transistors may comprise a tunnel oxide layer arranged between the charge trap and the gate, and a blocking oxide layer arranged between the charge trap and the channel of the memory transistor.

It is a realization that gate side injection operation facilitates a high programming efficiency. For conventional channel side injection operation, the maximum programming efficiency may be limited to 1. On the other hand, for gate side injection operation, the maximum programming efficiency may be given by the ratio between the first capacitance divided by the second capacitance. It is a realization that for gate side injection operation, the programming efficiency may be above 1.

A ratio of the first capacitance over the second capacitance may be between 1 and 10. Such a ratio may facilitate a high programming efficiency.

It is a further realization that programming disturbances may, advantageously, be suppressed in a different manner in gate side injection operation, as compared to channel side injection operation. In particular, it is a realization that applying a negative voltage to the word line of a memory transistor (such as the second transistor described above) during programming may mean that suppression of programming disturbances using conventional schemes work less effectively or not at all.

It is a realization that injecting holes into the channel of the memory transistor that is to be programmed (the second transistor of the first string) may facilitate programming of said transistor by gate side injection. For example, if there are holes in the channel of a memory transistor it may be easier to tunnel electrons from the gate to the charge trap of the memory transistor thanks to the higher electric field, i.e. tunnel the negatively charged electrons in the direction towards the positively charged holes on the opposite side of the charge trap. This may facilitate a high programming efficiency.

It is a further realization that if said holes are provided in the first string by GIDL (e.g. GIDL in a transistor different from the second transistor, such as the first transistor), then the second string may be deprived of holes when the difference between the second and third voltages is smaller than a difference between the first and third voltages. In other words, the first string may be provided with holes, which facilitate gate side injection (and thereby facilitates programming); while the second string is deprived of holes, which inhibits gate side injection (and thereby inhibits programming disturbances).

Gate-induced drain leakage current (GIDL) generates holes due to band-to-band tunnelling. Herein, electrons may tunnel through the energy barrier between the valence band and the conduction band, thereby creating holes. GIDL may be controlled by controlling the potential difference between the drain or source and the gate of a transistor.

During the formation of holes in the first transistor of the first string, the third voltage is applied to the control line (i.e. selector line or word line) of the first transistor of the first string, thereby applying said third voltage to the gate of the first transistor of the first string. Said third voltage may simultaneously be applied, via the control line, to a first transistor of the second string.

As mentioned, the first voltage is applied to the first bit line and a second voltage is applied to the second bit line. Thus, the first voltage may be applied to the drain of the first transistor of the first string and the second voltage may be applied to the drainof the first transistor of the second string. Since the first transistor of the first string and the first transistor of the second string are provided with the same voltage (third voltage), setting a difference between the second and third voltages to be smaller than a difference between the first and third voltages may ensure that the potential difference between the drain and the gate of the first transistor of the first string is smaller than the potential difference between the drain and the gate of the first transistor of the second string. Thus, while there is GIDL in the first transistor of the first string, GIDL in the first transistor of the second string may be smaller or completely prevented. Accordingly, more holes may be provided in the first string than in the second string.

As mentioned, the holes provided by GIDL in the first transistor of the first string are injected into the second transistor of the first string. The second transistor of the first string may be a transistor further away from the first bit line than the first transistor of the first string. A second transistor of the second string may be connected to the same control line as the second transistor of the first string. The second transistor of the first string may be a transistor on the source side of the first transistor of the first string (the same relationship may thus apply also to the first and second transistors of the second string).

The holes may be injected by providing a suitable voltage on the control line of the second transistor of the first string in relation to the first transistor of the first string (and suitable voltages on any intermediate control line between the first and second transistor of the first string). As the control lines are connected to gates of corresponding transistors on the first and second string, said voltages will also be provided to the second string. However, since GIDL is inhibited in the first transistor of the second string, there may be little or no holes to inject into the channel of the second transistor of the second string. Thus, erroneous programming by programming disturbances may be inhibited in the second transistor of the second string.

The method may be configured such that, during said act of providing holes by GIDL in the first transistor of the first string, a hole current through the first string is at least a factor 10 larger (e.g. at least a factor 50 or at least a factor 100 larger) than a hole current through the second string. Thus, there may be fewer holes in the second transistor of the second string compared to the second transistor of the first string, e.g. at least a factor 10 fewer. This may facilitate a sufficient suppression of programming disturbances in the second transistor of the second string.

The first, second, and third voltages may be configured such that a hole current through the first string is at least a factor 10 larger than a hole current through the second string during said act of providing holes by GIDL in the first transistor of the first string.

The method may be configured such that the second voltage is negative. This may further inhibit GIDL in the first transistor of the second string and thereby suppress programming disturbances in the second transistor of the second string.

The method may be configured such that the difference between the second and third voltages is less than 70% of the difference between the first and third voltages. This may further inhibit GIDL in the first transistor of the second string and thereby suppress programming disturbances in the second transistor of the second string. As an example, the difference between the second and third voltages may be less than 50% of the difference between the first and third voltages. As a further example, the first voltage may be 3V, the second voltage -3 V and the third voltage -7 V. In the latter example, the difference between the second and third voltages is 4V and the difference between the first and third voltages is 10V, i.e. the difference between the second and third voltages is 40% of the difference between the first and third voltages.

The method may be configured such that the difference between the first and third voltages is at least 7 V. This may facilitate sufficient GIDL in the first transistor of the first string.

The method may be configured such that the respective channels of the memory transistors of the first string are intrinsically doped. The use of GIDL is particularly advantageous in this situation. In recent 3D NAND memories, the dopant concentration of the channels of the strings is intrinsic. It is a realization that such channels do not connect to the p-type well. The creation of holes can in such cases advantageously be controlled by GIDL.

The programming of the second transistor of the first string may comprise applying a series of negative voltage pulses to the word line connected to the second transistor of the first string, wherein each subsequent pulse of the series of negative pulses increases in amplitude. The amplitude may be increased until a threshold voltage target is achieved. Such series of negative voltage pulses helps to achieve a tighter distribution of threshold voltages in the memory transistors. By applying incremental changes in programming pulses, more precise control over the final programmed state is facilitated. Such series of negative voltage pulses may further reduce (e.g. minimize) the programming disturbances to neighboring memory transistors. In view of the above, incremental step pulse programming (ISPP) may be used for programming the second transistor of the first string.

The method may be configured such that the third voltage is initiated subsequent to the initiation of the first and second voltages. This may further suppress programming disturbances in the second transistor of the second string.

The method may be implemented by the use of GIDL in the selector transistor of the first string or in a memory transistor of the first string. Below, example A describes using GIDL in the selector transistor of the first string and example B describes using GIDL in a memory transistor of the first string.

In the following, example A will be discussed.

The method may be configured such that the first transistor of the first string is the selector transistor, and the first and second transistors are separated by at least one memory transistor of the plurality of memory transistors of the first string,
wherein said act of injecting the holes into the channel of the second transistor comprises applying a negative voltage to the word line of the at least one memory transistor separating the first transistor and the second transistor, such that the holes provided in the first transistor pass through the channel of the memory transistor separating the first transistor and the second transistor.

The negative voltage applied to the word line of the at least one memory transistor separating the first transistor and the second transistor may be less negative than the programming voltage applied to the word line connected to the second transistor of the first string.

The negative voltage applied to the word line of the at least one memory transistor separating the first transistor and the second transistor may be the same as the third voltage or between the third voltage and the programming voltage applied to the word line connected to the second transistor of the first string. It should be understood that using GIDL in the selector transistor is applicable also when the second transistor is adjacent to the first transistor, such as when the second transistor is the memory transistor next to the selector transistor.

Further, the negative voltage applied to the word line of the at least one memory transistor separating the first transistor and the second transistor may be initiated subsequent to the initiation of the third voltage. This may further suppress programming disturbances in the second transistor of the second string.

In the following, example B will be discussed.

The method may be configured such that the first transistor and the second transistor of the first bit string are adjacent memory transistors of the plurality of memory transistors of the first string, and the first transistor and the first bit line are separated by at least one further transistor of the first string,
wherein the method further comprises applying a positive voltage to the control line of the at least one further transistor separating the first transistor and the first bit line, such that the voltage of the first bit line propagates through the at least one further transistor .

Thus, the first and second transistors of the first string may be neighboring memory transistors of the first bit line. In this example, there may be no transistors between the first and second transistors of the first string.

The positive voltage applied to the control line of the at least one further transistor separating the first transistor and the first bit line may be configured to turn on the at least one further transistor separating the first transistor and the first bit line. The positive voltage applied to the control line of the at least one further transistor separating the first transistor and the first bit line may be higher than the first voltage. The voltages of the control lines of the at least one further transistor separating the first transistor and the first bit line may not necessarily all have the same value.

Further, the first and second voltages may be initiated subsequent to the initiation of the positive voltage applied to the control line of the at least one further transistor separating the first transistor and the first bit line.

The memory transistors may be programmed sequentially.

Thus, in example B, the method may further comprise, subsequent to programming the second transistor:
providing holes by GIDL in a third transistor of the first string, wherein the third transistor is positioned on an opposite side of the first transistor relative to the second transistor;
injecting the holes provided by GIDL in the third transistor into the channel of the first transistor of the first string;
programming the first transistor by applying a negative voltage to the control line connected to the first transistor such that electrons tunnel from the gate of the first transistor to the charge trap of the first transistor.

In other words, the memory transistor which provides the holes by GIDL (first transistor) may subsequently be programmed. During said programming, a further transistor (third transistor) may provide the holes. Programming may start with a memory transistor some distance away from the first bit line, e.g. furthest away from the first bit line.

Consider an example where the string extend vertically, the first bit line is arranged over the string, the selector transistor is arranged at the top end of the string, followed by memory transistors 1-n below, wherein memory transistor 1 is closest to the first bit line and memory transistor n is furthest away. Programming may start with programming memory transistor n (being the second transistor in this example) while using memory transistor n-1 as the transistor for providing the holes by GIDL (being the first transistor in this example). Subsequently, memory transistor n-1 may be programmed, while using memory transistor n-2 (being the third transistor in this example) to provide the holes by GIDL. Programming may then continue one memory transistor at a time upwards until all memory transistors of the first string are programmed (or at least a bottom part of the memory transistors of the first string).

According to a second aspect, there is provided a non-volatile memory, the non-volatile memory comprising:
a first bit line and a second bit line;
a first string and a second string, the first string being connected to the first bit line and the second string being connected to the second bit line,
   each string comprising a plurality of transistors, the plurality of transistors comprising a selector transistor and a plurality of memory transistors, wherein each transistor comprises a source, a drain, a channel, and a gate, and each memory transistor further comprises a charge trap, wherein a first capacitance between the charge trap and the channel of the memory transistor is larger than a second capacitance between the charge trap and the gate of the memory transistor;
a plurality of control lines comprising
   a selector line connected to the gate of the selector transistor of the first string and to the selector transistor of the second string; and
   a plurality of word lines, each word line being connected to the gate of a memory transistor of the plurality of memory transistors of the first string and to a memory transistor of the plurality of memory transistors of the second string;
a controller, the controller being configured to
provide holes by gate induced drain leakage ,GIDL, in a first transistor of the first string, the first transistor being the selector transistor of the first string or one of the plurality of memory transistors of the first string,
inject the holes into the channel of a second transistor of the first string, the second transistor being one of the plurality of memory transistors of the first string; and
program the second transistor by applying a negative voltage to the word line connected to the second transistor such that electrons tunnel from the gate of the second transistor to the charge trap of the second transistor;
wherein, during the holes being provided, a first voltage is applied to the first bit line, a second voltage is applied to the second bit line and a third voltage is applied to the control line connected to the first transistor, the first voltage being positive and the third voltage being negative, wherein a difference between the second and third voltages is smaller than a difference between the first and third voltages.

A device according to the second aspect may have the same advantages, or similar advantages, as the advantages described in conjunction with the first aspect.

The controller may be any form of voltage controller for controlling the voltages of the control lines and the bit lines.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1a illustrates a non-volatile memory
Fig. 1b illustrates a selector transistor
Fig. 1c illustrates memory transistor
Fig. 2 illustrates a non-volatile memory
Fig. 3 illustrates a non-volatile memory
Fig. 4 illustrates a non-volatile memory

### DETAILED DESCRIPTION

In cooperation with attached drawings, the technical contents and detailed description of the present invention are described thereinafter according to a preferable embodiment, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

In the following, axes X, Y and Z indicate a first horizontal direction, a second horizontal direction transverse to the first horizontal direction, and a vertical direction, respectively. The X- and Y-direction may be parallel to a main plane of a substrate on which the non-volatile memory is arranged. The Z-direction may be parallel to a normal direction of the substrate.

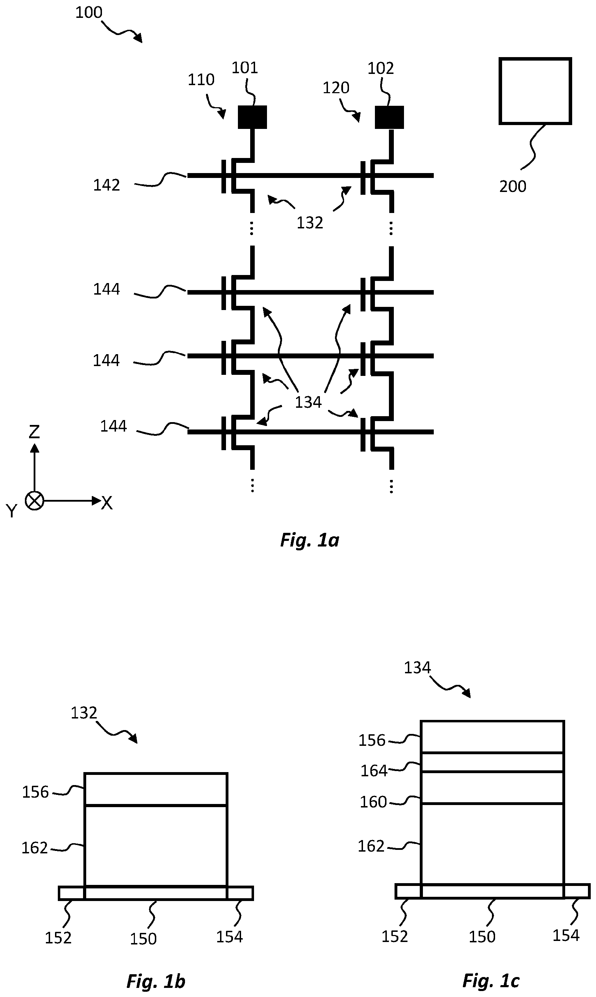

Fig. 1a is a schematic illustration of a non-volatile memory 100. The non-volatile memory 100 comprises a first bit line 101 and a second bit line 102; a first string 110 and a second string 120, the first string 110 being connected to the first bit line 101 and the second string 120 being connected to the second bit line 102. In the illustrated non-volatile memory 100, the first 101 and second 102 bit lines extend in the Y-direction.

Each string 110, 120 comprises a plurality of transistors, the plurality of transistors comprising a selector transistor 132 and a plurality of memory transistors 134. Each string 110, 120 may comprise further memory transistors 134 than the ones shown, as indicated by the dotted lines of each string. Additionally, the non-volatile memory 100 may comprise further bit lines and further strings.

In the illustrated non-volatile memory 100, the strings 110, 120 extend vertically (in the Z-direction) and the first 101 and second 102 bit line are arranged above the first 110 and second 120 string, respectively. In the illustrated non-volatile memory 100, the selector transistor 132 of each string is arranged at the top end and connected to the respective bit line.

Figs 1b and 1c are schematic illustrations of a selector transistor 132 and a memory transistor 134, respectively. As shown, each transistor (i.e. both the selector transistor 132 and the memory transistor 134) comprises a source 152, a drain 154, a channel 150, and a gate 156. The memory transistor 134 further comprises a charge trap 160. It should be noted that Figs 1b and 1c are schematic illustrations. In practice, each string of the non-volatile memory 100 may be arranged in a vertical hole of the non-volatile memory 100. Sources 152, drains 154, channels 150 of the transistors may be integrated in a first layer along the inner wall of the hole. Gates 156 may be integrated in a second layer along the inner wall of the hole. Charge traps 160 may be integrated in a third layer along the inner wall of the hole, between the first and second layer. As illustrated in Fig. 1c, the memory transistors 134 may comprise a blocking oxide layer 162 (first dielectric layer) arranged between the charge trap 160 and the channel 150, and a tunnel oxide layer 164 (second dielectric layer) arranged between the charge trap 160 and the gate 156. The blocking oxide layer 162 may be thicker than the tunnel oxide layer 164, e.g. at least 50% thicker or at least 100% thicker. As illustrated in Fig. 1b, the selector transistors 132 may comprise a blocking oxide layer 162 (e.g. solely a blocking oxide layer 162) between the channel 150 and the gate 156. As previously mentioned, a first capacitance between the charge trap 160 and the channel 150 of the memory transistor 134 is larger than a second capacitance between the charge trap 160 and the gate 156 of the memory transistor 134, e.g. as a consequence of thicknesses and/or materials of the blocking oxide layer 162 and tunnel oxide layer 164.

Coming back to Fig. 1a, the illustrated non-volatile memory 100 further comprises a selector line 142 connected to the gate 156 of the selector transistor 132 of the first string 110 and to the selector transistor 132 of the second string 120. The illustrated non-volatile memory 100 further comprises a plurality of word lines 144. Each word line 144 is connected to the gate 156 of a memory transistor 134 of the first string 110 and to the gate 156 of a memory transistor 134 of the second string 120. The selector line 142 and the word lines 144 may collectively be called control lines. In the illustrated non-volatile memory 100, the control lines extend in the X-direction.

The non-volatile memory 100 of Fig. 1a further comprises a controller 200 for controlling the voltages of the control lines 142, 144 and the bit lines 101, 102.

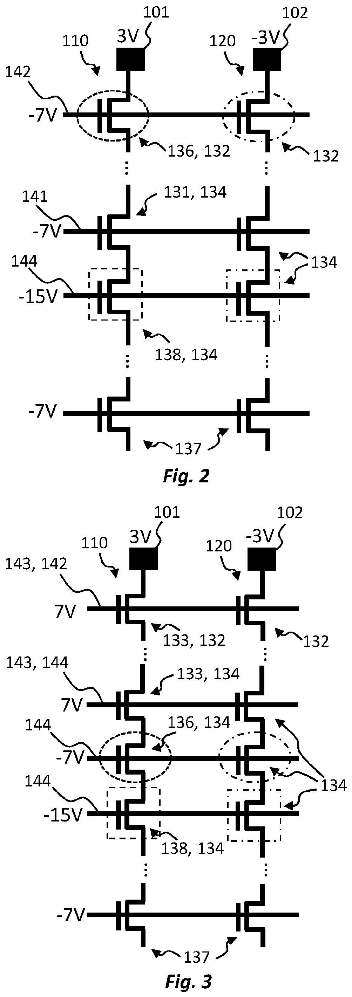

In the following, the method will be described according to the above mentioned examples. Example A, wherein the holes are provided by GIDL in the selector transistor 132 of the first string 110, is illustrated in Fig. 2. Example B, wherein the holes are provided by GIDL in a memory transistor 134 of the first string 110, is illustrated in Fig. 3. In the figures, transistors where GIDL occurs are marked by dashed ellipses and transistors where GIDL are inhibited are marked by dash-dotted ellipses. Memory transistors 134 where programming occurs are marked by dashed squares and memory transistors where programming is inhibited are marked by dash-dotted squares.

Fig. 2 (example A) shows providing holes by GIDL in a first transistor 136 of the first string 110. As mentioned, in Fig. 2 the first transistor 136 is the selector transistor 132 of the first string 110. In the figure, 3 V is applied to the drain of the first transistor 136 and -7 V is applied to the gate of the first transistor 136, thereby causing GIDL.

Fig. 2 further shows injecting the holes into the channel 150 of a second transistor 138 of the first string 110, the second transistor 138 being one of the memory transistors 134 of the first string 110. In the figure the holes are injected by applying a negative voltage (in the illustrated case -7 V) to the word line 141 of the memory transistors 131 separating the first transistor 136 and the second transistor 138, such that the holes provided in the first transistor 136 pass through the channels 150 of the memory transistors 131 separating the first transistor 136 and the second transistor 138.

Fig. 2 further shows programming the second transistor 138 by applying a negative voltage (in the illustrated case -15 V) to the word line 144 connected to the second transistor 138 such that electrons tunnel from the gate 156 of the second transistor 138 to the charge trap 160 of the second transistor 138.

In Fig. 2, during the act of providing the holes, a first voltage is applied to the first bit line 101, a second voltage is applied to the second bit line 102 and a third voltage is applied to the control line (selector line 142) connected to the first transistor 136. In the illustrated example, the first voltage is 3 V, the second voltage is -3 V, and the third voltage is -7 V. Thus, as illustrated, the first voltage is positive, the third voltage is negative, and a difference between the second and third voltages (4 V) is smaller than a difference between the first and third voltages (10 V). Thus, as illustrated, while GIDL occurs in the selector transistor 132 of the first string 110, GIDL is inhibited in the selector transistor 132 of the second string 120.

In the example, a voltage of -7V may be applied to the gates of the memory transistors 134 below the second transistor 138. Further, a voltage of -7 V may be applied to the gate of a bottom selector transistor 137.

It should be understood that other voltages than the voltages of this example may be used. It should further be understood that the above mentioned voltages may not necessarily be initiated simultaneously. For example, the third voltage may be initiated subsequent to the initiation of the first and second voltages. Further, the negative voltage applied to the word lines 141 of the transistors 131 separating the first transistor 136 and the second transistor 138 may be initiated subsequent to the initiation of the third voltage.

Fig. 3 (example B) shows providing holes by GIDL in a memory transistor 134 of the first string 110. Thus, in Fig. 3, the first transistor 136 (where GIDL occurs) is one of the memory transistors 134 of the first string 110. Further, in the figure, the second transistor 138 (the memory transistor 134 being programmed) is adjacent to the first transistor 136. The figure further shows further transistors 133 of the first string 110 between the first transistor 136 and the first bit line 101. In the figure, the further transistors 133 comprise both the selector transistor 132 and memory transistors 133.

In the figure, 3 V is applied to the first bit line 101 and a positive voltage (in this case 7 V) is applied to the control lines 143 of the further transistors 133 separating the first transistor 136 and the first bit line 101, such that the voltage (3 V in the example) of the first bit line 101 propagates through the further transistors 133. Thus, in the example, 3 V is applied to the drain of the first transistor 136. Further, in the example, -7 V is applied to the gate of the first transistor 136, thereby causing GIDL.

In the figure, -15 V is applied to the word line 144 connected to the second transistor 138. Thereby, holes are injected into the channel 150 of the second transistor 138 of the first string 110 and the second transistor 138 is programmed by electrons tunnelling from the gate 156 of the second transistor 138 to the charge trap 160 of the second transistor 138.

In Fig. 3, during the act of providing the holes, a first voltage is applied to the first bit line 101, a second voltage is applied to the second bit line 102 and a third voltage is applied to the control line connected to the first transistor 136. In the illustrated example, the first voltage is 3 V, the second voltage is -3 V, and the third voltage is -7 V. Thus, as illustrated, the first voltage is positive, the third voltage is negative, and a difference between the second and third voltages (4 V) is smaller than a difference between the first and third voltages (10 V). Thus, as illustrated, although there is a corresponding memory transistor 134 in the second string 120 connected to the same word line 144 as the first transistor 136 of the first string 110, GIDL only occurs in the first transistor 136 and not on said corresponding memory transistor of the second string 120.

In the example, a voltage of -7V may be applied to the gates of memory transistors 134 below the second transistor 138. Further, a voltage of -7 V may be applied to the gate of a bottom selector transistor 137.

It should be understood that other voltages than the voltages of this example may be used. It should further be understood that the above mentioned voltages may not necessarily be initiated simultaneously. For example, the third voltage may be initiated subsequent to the initiation of the first and second voltages. Further, the first and second voltages may be initiated subsequent to the initiation of the positive voltage applied to the control lines 143 of the further transistors 133 separating the first transistor 136 and the first bit line 101.

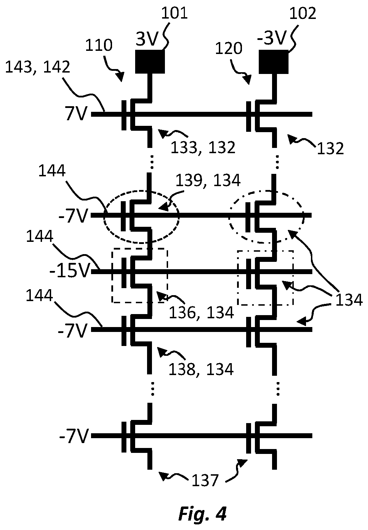

As mentioned earlier, the memory transistors 134 may be programmed sequentially. This is illustrated in Fig. 4.

Fig. 4 illustrates a step subsequent to the step of Fig. 3, i.e. subsequent to programming the second transistor 138. As shown, holes are provided by GIDL in a third transistor 139 of the first string 110, wherein the third transistor 139 is positioned on an opposite side of the first transistor 136 relative to the second transistor 138, in the illustrated case on the side towards the first bit line 101. The holes provided by GIDL in the third transistor 139 are injected into the channel 150 of the first transistor 136 of the first string 110. The first transistor 136 is programmed by applying a negative voltage to the control line 144 connected to the first transistor 136 such that electrons tunnel from the gate 156 of the first transistor 136 to the charge trap 160 of the first transistor 136.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for writing to a non-volatile memory (100), the non-volatile memory (100) comprising:
a first bit line (101) and a second bit line (102);
a first string (110) and a second string (120), the first string (110) being connected to the first bit line (101) and the second string (120) being connected to the second bit line (102),
each string (110, 120) comprising a plurality of transistors, the plurality of transistors comprising a selector transistor (132) and a plurality of memory transistors (134), wherein each transistor comprises a source (152), a drain (154), a channel (150), and a gate (156), and each memory transistor (134) further comprises a charge trap (160), wherein a first capacitance between the charge trap (160) and the channel (150) of the memory transistor (134) is larger than a second capacitance between the charge trap (160) and the gate (156) of the memory transistor (134);
a plurality of control lines comprising
a selector line (142) connected to the gate (156) of the selector transistor (132) of the first string (110) and to the selector transistor (132) of the second string (120); and
a plurality of word lines (144), each word line (144) being connected to the gate (156) of a memory transistor (134) of the plurality of memory transistors (134) of the first string (110) and to a memory transistor (134) of the plurality of memory transistors (134) of the second string (120);
the method comprising:
providing holes by gate induced drain leakage ,GIDL, in a first transistor (136) of the first string (110), the first transistor (136) being the selector transistor (132) of the first string or one of the plurality of memory transistors (134) of the first string (110),
injecting the holes into the channel (150) of a second transistor (138) of the first string (110), the second transistor (138) being one of the plurality of memory transistors (134) of the first string (110); and
programming the second transistor (138) by applying a negative voltage to the word line (144) connected to the second transistor (138) such that electrons tunnel from the gate (156) of the second transistor (138) to the charge trap (160) of the second transistor (138);
wherein, during said act of providing the holes, a first voltage is applied to the first bit line (101), a second voltage is applied to the second bit line (102) and a third voltage is applied to the control line connected to the first transistor (136), the first voltage being positive and the third voltage being negative, wherein a difference between the second and third voltages is smaller than a difference between the first and third voltages.

2. The method according to any one of the preceding claims, wherein a ratio of the first capacitance over the second capacitance is between 1 and 10

3. The method according to any one of the preceding claims, wherein, during said act of providing holes by GIDL in the first transistor (136) of the first string (110), a hole current through the first string (110) is at least a factor 10 larger than a hole current through the second string (120).

4. The method according to any one of the preceding claims, wherein the second voltage is negative.

5. The method according to any one of the preceding claims, wherein the difference between the second and third voltages is less than 70% of the difference between the first and third voltages.

6. The method according to any one of the preceding claims, wherein the difference between the first and third voltages is at least 7 V.

7. The method according to any one of the preceding claims, wherein the respective channels (150) of the memory transistors (134) of the first string (110) are intrinsically doped.

8. The method according to any one of the preceding claims, wherein said act of programming the second transistor (138) comprises applying a series of negative voltage pulses to the word line (144) connected to the second transistor (138) of the first string (110), wherein each subsequent pulse of the series of negative pulses increases in amplitude.

9. The method according to any one of the preceding claims, wherein the third voltage is initiated subsequent to the initiation of the first and second voltages.

10. The method according to any one of the preceding claims, wherein the first transistor (136) of the first string (110) is the selector transistor (132), and the first (136) and second (138) transistors are separated by at least one memory transistor (131) of the plurality of memory transistors (134) of the first string (110),
wherein said act of injecting the holes into the channel (150) of the second transistor (138) comprises applying a negative voltage to the word line (141) of the at least one memory transistor (131) separating the first transistor (136) and the second transistor (138), such that the holes provided in the first transistor (136) pass through the channel (150) of the memory transistor (131) separating the first transistor (136) and the second transistor (138).

11. The method according to claim 10, wherein the negative voltage applied to the word line (141) of the at least one memory transistor (131) separating the first transistor (136) and the second transistor (138) is initiated subsequent to the initiation of the third voltage.

12. The method according to any one of claims 1-9, wherein the first transistor (136) and the second transistor (138) are adjacent memory transistors of the plurality of memory transistors (134) of the first string (110), and the first transistor (136) and the first bit line (101) are separated by at least one further transistor (133) of the first string (110),
wherein the method further comprises applying a positive voltage to the control line (143) of the at least one further transistor (133) separating the first transistor (136) and the first bit line (101), such that the voltage of the first bit line (101) propagates through the at least one further transistor (133) .

13. The method according to claim 12, wherein the first and second voltages are initiated subsequent to the initiation of the positive voltage applied to the control line (143) of the at least one further transistor (133) separating the first transistor (136) and the first bit line (101).

14. The method according to claim 12 or 13, the method further comprising, subsequent to programming the second transistor (138):
providing holes by GIDL in a third transistor (139) of the first string (110), wherein the third transistor (139) is positioned on an opposite side of the first transistor (136) relative to the second transistor (138);
injecting the holes provided by GIDL in the third transistor (139) into the channel (150) of the first transistor (136) of the first string (110);
programming the first transistor (136) by applying a negative voltage to the control line (144) connected to the first transistor (136) such that electrons tunnel from the gate (156) of the first transistor (136) to the charge trap (160) of the first transistor (136).

15. A non-volatile memory (100), the non-volatile memory (100) comprising:
a first bit line (101) and a second bit line (102);
a first string (110) and a second string (120), the first string (110) being connected to the first bit line (101) and the second string (120) being connected to the second bit line (102),
each string (110, 120) comprising a plurality of transistors, the plurality of transistors comprising a selector transistor (132) and a plurality of memory transistors (134), wherein each transistor comprises a source (152), a drain (154), a channel (150), and a gate (156), and each memory transistor (134) further comprises a charge trap (160), wherein a first capacitance between the charge trap (160) and the channel (150) of the memory transistor (134) is larger than a second capacitance between the charge trap (160) and the gate (156) of the memory transistor (134);
a plurality of control lines comprising
a selector line (142) connected to the gate (156) of the selector transistor (132) of the first string (110) and to the selector transistor (132) of the second string (110); and
a plurality of word lines (144), each word line (144) being connected to the gate (156) of a memory transistor (134) of the plurality of memory transistors (134) of the first string (110) and to a memory transistor (134) of the plurality of memory transistors (134) of the second string (120);
a controller (200), the controller (200) being configured to provide holes by gate induced drain leakage ,GIDL, in a first transistor (136) of the first string (110), the first transistor (136) being the selector transistor (132) of the first string or one of the plurality of memory transistors (134) of the first string (110),
inject the holes into the channel (150) of a second transistor (138) of the first string (110), the second transistor (138) being one of the plurality of memory transistors (134) of the first string (110); and
program the second transistor (138) by applying a negative voltage to the word line (144) connected to the second transistor (138) such that electrons tunnel from the gate (156) of the second transistor (138) to the charge trap (160) of the second transistor (138);
wherein, during the holes being provided, a first voltage is applied to the first bit line (101), a second voltage is applied to the second bit line (102) and a third voltage is applied to the control line connected to the first transistor (136), the first voltage being positive and the third voltage being negative, wherein a difference between the second and third voltages is smaller than a difference between the first and third voltages.
